# EUROPÄISCHE PATENTANMELDUNG

(11) **EP 1 195 900 A2**
(43) Veröffentlichungstag der Anmeldung: **10.04.2002**
(21) Anmeldenummer: 01119856.1
(22) Anmeldetag: 16.08.2001
(51) Int. Cl.: H03K 3/286

(54) **Selbstverriegelnde Schaltungsanordnung**

(30) Priorität: 28.09.2000 DE 10048188
(71) Anmelder: Patent-Treuhand-Gesellschaft für elektrische Glühlampen mbH, 81543 München (DE)
(72) Erfinder: Haeusser-Boehm, Helmut, Dr., 81547 Muenchen (DE); Schaller, Michael, 83301 Traunreut (DE)

(57) **Zusammenfassung**

Die vorliegende Erfindung betrifft eine selbstverriegelnde Schaltungsanordnung mit einem Eingangsspannungsanschluß zum Anlegen einer Eingangsspannung (UE), einem Ausgangsspannungsanschluß zum Bereitstellen einer Ausgangsspannung (UA), einem Versorgungsspannungsanschluß zum Anschluß einer Versorgungsspannung (UV), einem ersten Schaltelement (T1) mit einem ersten und einem zweiten Ausgangsanschluß und einem Steueranschluß, einem zweiten Schaltelement (T2) mit einem ersten und einem zweiten Ausgangsanschluß und einem Steueranschluß, wobei der erste Ausgangsanschluß des ersten Schaltelements (T1) mit dem Ausgangsspannungsanschluß, der zweite Ausgangsanschluß des ersten Schaltelements (T1) mit einem Bezugspotential verbunden ist, der erste Ausgangsanschluß des zweiten Schaltelements (T2) sowie der Steueranschluß des ersten Schaltelements (T1) mit dem Eingangsspannungsanschluß, der zweite Ausgangsanschluß des zweiten Schaltelements (T2) mit dem Bezugspotential verbunden ist, und der Steueranschluß des zweiten Schaltelements (T2) mit dem Ausgangsspannungsanschluß verbunden ist.

## Beschreibung

### Technisches Gebiet

Die vorliegende Erfindung betrifft eine selbstverriegelnde Schaltungsanordnung mit einem Eingangsspannungsanschluß zum Anlegen einer Eingangsspannung, einem Ausgangsspannungsanschluß zum Bereitstellen einer Ausgangsspannung, einem Versorgungsspannungsanschluß zum Anschluß einer Versorgungsspannung, einem ersten Schaltelement mit einem ersten und einem zweiten Ausgangsanschluß und einem Steueranschluß, sowie einem zweiten Schaltelement mit einem ersten und einem zweiten Ausgangsanschluß und einem Steueranschluß.

### Stand der Technik

Aus dem Stand der Technik sind selbstverriegelnde Schaltungsanordnungen mit Thyristoren bekannt. Diese bieten beispielsweise Schutz für den Fall, daß eine Spannung zu groß wird. Wächst beispielsweise eine Spannung über einen bestimmten Wert an, zündet der Thyristor, wodurch bei geeigneter Beschaltung die Ausgangsspannung auf 0 Volt zurückgeht. Unter selbstverriegelnden Schaltungsanordnungen sind hierbei Schaltungsanordnungen zu verstehen, deren Abschaltung irreversibel sein soll, das heißt ein Weiterbetrieb des davon gespeisten Geräts ist nur durch einen Netzreset oder dergleichen möglich.

Im nichtabgeschalteten Zustand liegt die Ausgangsspannung einer selbstverriegelnden Schaltungsanordnung mit einem Thyristor üblicherweise im Bereich der Versorgungsspannung.

### Darstellung der Erfindung

Ausgehend von diesem Stand der Technik liegt der vorliegenden Erfindung die Aufgabe zugrunde, eine gattungsgemäße selbstverriegelnde Schaltungsanordnung derart weiterzubilden, daß auf einen Thyristor verzichtet werden kann und eine sichere, irreversible Abschaltung dann bewirkt werden kann, wenn die Eingangsspannung unter einen vorbestimmten Wert absinkt.

Diese Aufgabe wird gelöst, indem bei der gattungsgemäßen selbstverriegelnden Schaltungsanordnung der erste Ausgangsanschluß des ersten Schaltelements mit dem Ausgangsspannungsanschluß, der zweite Ausgangsanschluß des ersten Schaltelements mit einem Bezugspotential verbunden ist, der erste Ausgangsanschluß des zweiten Schaltelements sowie der Steueranschluß des ersten Schaltelements mit dem Eingangsspannungsanschluß, der zweite Ausgangsanschluß des zweiten Schaltelements mit dem Bezugspotential verbunden ist und der Steueranschluß des zweiten Schaltelements mit dem Ausgangsspannungsanschluß verbunden ist.

Der vorliegenden Erfindung liegt die Erkenntnis zugrunde, daß durch geeignete Verschaltung zweier Transistoren, insbesondere zweier Bipolartransistoren, auf einfache und preiswerte Weise eine selbstverriegelnde Schaltungsanordnung realisierbar ist.

Bevorzugt wird das erste und/oder das zweite Schaltelement durch einen Bipolartransistor oder einen Feldeffekttransistor realisiert. Hierdurch läßt sich der Vorteil erzielen, daß die Schaltung mit sehr geringer Ansteuerleistung betrieben werden kann, da deutlich weniger Energie aufgebracht werden muß wie zum Zünden eines Thyristors.

Bevorzugt ist die Schaltung so ausgelegt, daß die Verriegelung der Schaltungsanordnung durch ein einmaliges Absenken der Eingangsspannung unter einen vorgebbaren Wert bewirkbar ist. Diese Schaltung ermöglicht daher sicherzustellen, daß ein Abschaltvorgang ausgelöst wird, wenn die Versorgungsspannung eines anderen Geräts, die als Eingangsspannung der selbstverriegelnden Schaltunganordnung dient, unter einen vorgegebenen Wert absinkt.

Durch Verwendung geeigneter Schaltmaßnahmen läßt sich erreichen, daß bei Sperrung der Schaltungsanordnung die Ausgangsspannung eine Spannung annimmt, die der Versorgungsspannung multipliziert mit einem Faktor a entspricht, wobei 0 ≤ a ≤ 1 ist. Am Steueranschluß des zweiten Schaltelements kann eine Spannung bereitstellbar sein, die der Versorgungsspannung multipliziert mit einem Faktor b entspricht, wobei 0 ≤ b ≤ 1 ist. Bevorzugt wird dies durch Verwendung eines Spannungsteilers erreicht.

Bevorzugt läßt sich die Sperrung der erfindungsgemäßen Schaltungsanordnung durch kurzzeitiges Abkoppeln der Versorgungsspannung oder Kurzschließen der Ausgangsspannung, insbesondere durch einen Schalter, Taster oder Transistor, aufheben.

Weitere vorteilhafte Ausführungsformen ergeben sich aus den Unteransprüchen.

### Beschreibung der Zeichnungen

Nachfolgend wird nunmehr ein Ausführungsbeispiel unter Hinweis auf die beigefügten Zeichnungen näherer beschrieben. Es stellen dar :
- Figur 1: ein Ausführungsbeispiel einer erfindungsgemäßen Schaltungsanordnung; und
- Figur 2: in schematischer Darstellung den zeitlichen Verlauf der Eingangsspannung UE und der Ausgangsspannung UA.

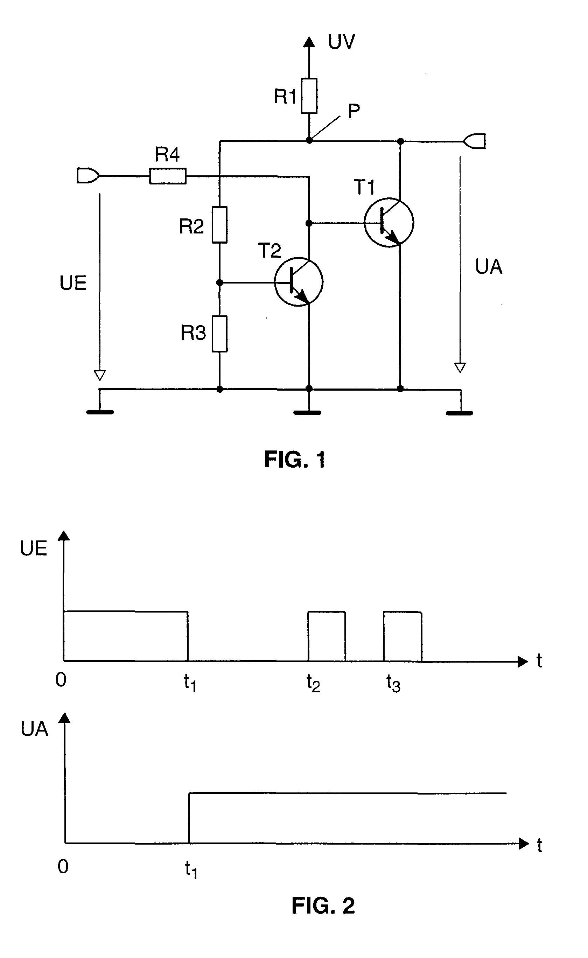

Figur 1 zeigt eine selbstverriegelnde Schaltungsanordnung, die einen Eingangsspannungsanschluß zum Anlegen einer Eingangsspannung UE aufweist, einen Ausgangsanschluß zum Bereitstellen einer Ausgangsspannung UA, sowie einen Versorgungsspannungsanschluß zum Anschluß einer Versorgungsspannung UV. Sie umfasst einen Transistor T1 und einen Transistor T2. Der Kollektor des Transistors T1 ist zum einen mit dem Ausgangsanschluß verbunden, zum anderen über einen Widerstand R1 mit der Versorgungsspannung UV. Der Emitter des Transistors T1 liegt auf Bezugspotential. Die Ausgangsspannung UA wird über einen Spannungsteiler, umfassend die Widerstände R2 und R3, geteilt, wobei die am Widerstand R3 abfallende Spannung an die Basis des Transistors T2 angelegt wird. Die Basis des Transistors T1 ist zum einen über einen Widerstand R4 mit dem Eingangsanschluß verbunden, zum anderen mit dem Kollektor des Transistors T2. Der Emitter des Transistors T2 liegt wiederum auf Bezugspotential.

Zur Funktion der in Figur 1 dargestellten selbstverriegelnden Schaltungsanordnung: Zunächst ist die Eingangsspannung UE groß, und zwar so groß, dass der Spannungsabfall zwischen Basis und Emitter des Transistors T1 genügt, um den Transistor T1 in den leitenden Zustand zu schalten. Infolge des leitenden Zustands von T1 ist die Ausgangsspannung UA 0 Volt. Damit liegt aber auch an der Basis des Transistors T2 keine Spannung an, das heißt, der Transistor T2 befindet sich im nichtleitenden Zustand. Die entsprechenden Spannungsverläufe sind in Figur 2 dargestellt, wobei der Anfangszustand den Zeitraum 0 bis t1 betrifft. Zum Zeitpunkt t1 geht die Eingangsspannung UE zurück. Damit sinkt die Basis - Emitter - Spannung des Transistors T1 soweit ab, dass dieser in den nichtleitenden Zustand übergeht. Nun ist Punkt P nicht mehr über den Transistor T1 kurzgeschlossen. Demnach steigt UA auf einen Wert an, der im wesentlichen abhängt von der Versorgungsspannung UV und den Widerständen R1, R2 und R3. Aufgrund dieses Ansteigens von UA fällt am Widerstand R3 eine Spannung ab, die bei geeigneter Dimensionierung dazu dient, den Transistor T2 in den leitenden Zustand zu schalten. Sobald der Transistor T2 im leitenden Zustand ist, ist der Spannungsabfall zwischen Basis und Emitter von Transistor T1 immer gleich 0. Damit befindet sich Transistor T1 fest im nichtleitenden Zustand. Die Schaltungsanordnung ist damit im verriegelten Zustand.

Änderungen der Eingangsspannung, siehe beispielsweise die Impulse zu den Zeitpunkten t2 und t3 in Figur 2, können infolge des sich im leitenden Zustand befindenden Transistors T2 die Verriegelung nicht rückgängig machen. Dies ist nur möglich durch kurzzeitiges Abkoppeln der Versorgungsspannung oder Kurzschließen der Ausgangsspannung insbesondere durch einen Schalter, Taster oder Transistor.

Wie für den Fachmann offensichtlich kann die Schaltung auch mit anderen Schaltelementen, beispielsweise Feldeffekttransistoren, oder komplementären Bauelementen, z.B. pnp-Transistoren anstelle der in Figur 1 dargestellten npn-Transistoren, realisiert werden.

## Patentansprüche

1. Selbstverriegelnde Schaltungsanordnung mit
- einem Eingangsspannungsanschluß zum Anlegen einer Eingangsspannung (UE);
- einem Ausgangsspannungsanschluß zum Bereitstellen einer Ausgangsspannung (UA);
- einem Versorgungsspannungsanschluß zum Anschluß einer Versorgungsspannung (UV);
- einem ersten Schaltelement (T1) mit einem ersten und einem zweiten Ausgangsanschluß und einem Steueranschluß;
- einem zweiten Schaltelement (T2) mit einem ersten und einem zweiten Ausgangsanschluß und einem Steueranschluß;
**dadurch gekennzeichnet,**
**daß** der erste Ausgangsanschluß des ersten Schaltelements (T1) mit dem Ausgangsspannungsanschluß, der zweite Ausgangsanschluß des ersten Schaltelements (T1) mit einem Bezugspotential verbunden ist;
der erste Ausgangsanschluß des zweiten Schaltelements (T2) sowie der Steueranschluß des ersten Schaltelements (T1) mit dem Eingangsspannungsanschluß, der zweite Ausgangsanschluß des zweiten Schaltelements (T2) mit dem Bezugspotential verbunden ist; und
der Steueranschluß des zweiten Schaltelements (T2) mit dem Ausgangsspannungsanschluß verbunden ist.

2. Schaltungsanordnung nach Anspruch 1,
**dadurch gekennzeichnet,**
**daß** das erste und/oder das zweite Schaltelement (T1; T2) einen Bipolartransistor oder einen Feldeffekttransistor umfaßt.

3. Schaltungsanordnung nach Anspruch 1 oder 2,
**dadurch gekennzeichnet,**
**daß** eine Sperrung der Schaltungsanordnung durch ein einmaligen Absenken der Eingangsspannung (UE) unter einen vorgebbaren Wert bewirkbar ist.

4. Schaltungsanordnung nach einem der vorhergehenden Ansprüche,
**dadurch gekennzeichnet,**
**daß** bei Sperrung der Schaltungsanordnung die Ausgangsspannung (UA) eine Spannung annehmen kann, die der Versorgungsspannung multipliziert mit einem Faktor a entspricht, wobei
0 ≤ a ≤ 1 ist.

5. Schaltungsanordnung nach einem der vorhergehenden Ansprüche,
**dadurch gekennzeichnet,**
**daß** am Steueranschluß des zweiten Schaltelements (T2) eine Spannung bereitstellbar ist, die der Versorgungsspannung (UV) multipliziert mit einem Faktor b entspricht, wobei 0 ≤ b ≤ 1 ist.

6. Schaltungsanordnung nach einem der vorhergehenden Ansprüche,
**dadurch gekennzeichnet,**
**daß** die Sperrung der Schaltungsanordnung durch kurzzeitiges Abkoppeln der Versorgungsspannung (UV) oder Kurzschließen der Ausgangsspannung (UA), insbesondere durch einen Schalter, Taster oder Transistor, aufhebbar ist.
